# EUROPEAN PATENT APPLICATION

(11) **EP 4 336 985 A1**
(43) Date of publication of application: **13.03.2024**
(21) Application number: 23181308.0
(22) Date of filing: 23.06.2023
(51) Int. Cl.: H10B 41/41, H10B 41/50, H10B 43/40, H10B 43/50

(54) **SEMICONDUCTOR MEMORY DEVICE AND ELECTRONIC SYSTEM INCLUDING THE SAME**

(30) Priority: 07.09.2022 KR 20220113687
(71) Applicant: Samsung Electronics Co., Ltd., Suwon-si, Gyeonggi-do 16677 (KR)
(72) Inventor: KIM, Seungyeon, 16677 Suwon-si (KR); KIM, Jiyoung, 16677 Suwon-si (KR); KANG, In Ho, 16677 Suwon-si (KR); YANG, Woosung, 16677 Suwon-si (KR); LEE, Jae-Eun, 16677 Suwon-si (KR)
(74) Representative: Marks & Clerk LLP

(57) **Abstract**

A semiconductor memory includes a substrate that includes pass transistor regions, a peripheral circuit structure that includes pass transistors on the pass transistor regions, and a cell array structure on the peripheral circuit structure, the cell array structure including a plurality of cell array regions and a plurality of connection regions that are alternately arranged along a first direction. The cell array structure includes a stack structure including conductive patterns vertically stacked and correspondingly connected to the pass transistors. The stack structure includes stepwise structures on the connection regions. The connection regions of the cell array structure correspondingly overlap the pass transistor regions of the peripheral circuit structure.

## Description

### BACKGROUND

This disclosure relates to a semiconductor memory device and an electronic system including the same.

It may be necessary to have a semiconductor device capable of storing a large amount of data in an electronic system which requires data storage. Therefore, studies have been conducted to increase data storage capacity of the semiconductor device. For example, as an approach to increase data storage capacity of the semiconductor device, a semiconductor device is suggested to include three-dimensionally arranged memory cells instead of two-dimensionally arranged memory cells.

### SUMMARY

One or more example embodiments provide a semiconductor memory device with improved reliability and increased integration and an electronic system including a semiconductor memory device.

According to an aspect of an example embodiment, a semiconductor memory device includes: a substrate comprising a plurality of pass transistor regions; a peripheral circuit structure comprising a plurality of pass transistors on the pass transistor regions; and a cell array structure on the peripheral circuit structure, the cell array structure comprising a plurality of cell array regions and a plurality of connection regions that are alternately arranged along a first direction, wherein the cell array structure comprises a stack structure comprising a plurality of conductive patterns vertically stacked and correspondingly connected to the pass transistors, wherein the stack structure comprises a plurality of stepwise structures on the connection regions, and wherein the connection regions of the cell array structure correspondingly overlap the pass transistor regions of the peripheral circuit structure.

According to an aspect of an example embodiment, a semiconductor memory device includes: a substrate comprising a plurality of pass transistor regions and a plurality of page buffer regions; a peripheral circuit structure comprising a plurality of peripheral circuits and a plurality of first bonding pads connected to the peripheral circuits, the peripheral circuits being integrated on the substrate; and a cell array structure comprising a plurality of second bonding pads coupled to the first bonding pads, the cell array structure comprising a plurality of cell array regions and a plurality of connection regions alternately disposed along a first direction, wherein the peripheral circuits of the peripheral circuit structure comprises: a plurality of pass transistors on the pass transistor regions; and a plurality of page buffer circuits on the page buffer regions, wherein the cell array structure comprises: a stack structure comprising a plurality of vertically stacked conductive patterns, the stack structure having a stepwise structure on each of the connection regions; a plurality of vertical structures that penetrate the stack structure on the cell array regions; a plurality of bit lines that cross the stack structure and are connected to the vertical structures; and a plurality of cell contact plugs through which ends of the conductive patterns and the pass transistors are correspondingly connected on the connection regions, wherein the connection regions of the cell array structure correspondingly overlap the pass transistor regions of the peripheral circuit structure, and wherein the cell array regions of the cell array structure correspondingly overlap the page buffer regions of the peripheral circuit structure.

According to an aspect of an example embodiment, an electronic system includes: a semiconductor memory device comprising a substrate that comprises a plurality of pass transistor regions, a peripheral circuit structure that comprises a plurality of pass transistors on the pass transistor regions, and a cell array structure on the peripheral circuit structure, the cell array structure comprising a plurality of cell array regions and a plurality of connection regions that are alternately disposed along one direction; and a controller electrically connected through an input/output pad to the semiconductor memory device, the controller controlling the semiconductor memory device, wherein the cell array structure comprises a stack structure including a plurality of vertically stacked conductive patterns that are correspondingly connected to the pass transistors, wherein the stack structure has a plurality of stepwise structures on the connection regions, and wherein the connection regions of the cell array structure correspondingly overlap the pass transistor regions of the peripheral circuit structure.

At least some of the above and other features of the invention are set out in the claims.

### BRIEF DESCRIPTION OF THE DRAWINGS

The above and other aspects and features will be more apparent from the following description of example embodiments, taken in conjunction with the accompanying drawings, in which:
FIG. 1 illustrates a block diagram showing a semiconductor memory device according to an embodiment.
FIG. 2 illustrates a simplified perspective view showing a semiconductor memory device according to an embodiment.
FIG. 3 illustrates a simplified circuit diagram showing a semiconductor memory device according an embodiment.
FIG. 4 illustrates a simplified layout showing a semiconductor memory device according to an embodiment.
FIG. 5 illustrates a simplified cross-sectional view showing a semiconductor memory device according to an embodiment.
FIGS. 6 and 7 illustrate simplified perspective views showing a cell array structure of a semiconductor memory device according to an embodiment.
FIG. 8 illustrates a simplified layout showing a semiconductor memory device according to an embodiment.
FIGS. 9 and 10 illustrate cross-sectional views showing a semiconductor memory device according to an embodiment.
FIGS. 11 and 12 illustrate cross-sectional views of section P1 of FIGS. 9 and 10, showing a semiconductor memory device according to an embodiment.
FIGS. 13 and 14 illustrate cross-sectional views of section P2 of FIGS. 9 and 10, showing a semiconductor memory device according to an embodiment.
FIG. 15 illustrates a simplified schematic diagram showing an electronic system including a semiconductor memory device according to an embodiment.
FIG. 16 illustrates a simplified perspective view showing an electronic system including a semiconductor memory device according to an embodiment.
FIGS. 17 and 18 illustrate simplified cross-sectional views showing a semiconductor package according to an embodiment.

### DETAILED DESCRIPTION OF EMBODIMENTS

Example embodiments will be described more fully with reference to the accompanying drawings, in which example embodiments are shown. Embodiments described herein are provided as examples, and thus, the present disclosure is not limited thereto, and may be realized in various other forms. Each embodiment provided in the following description is not excluded from being associated with one or more features of another example or another embodiment also provided herein or not provided herein but consistent with the present disclosure. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

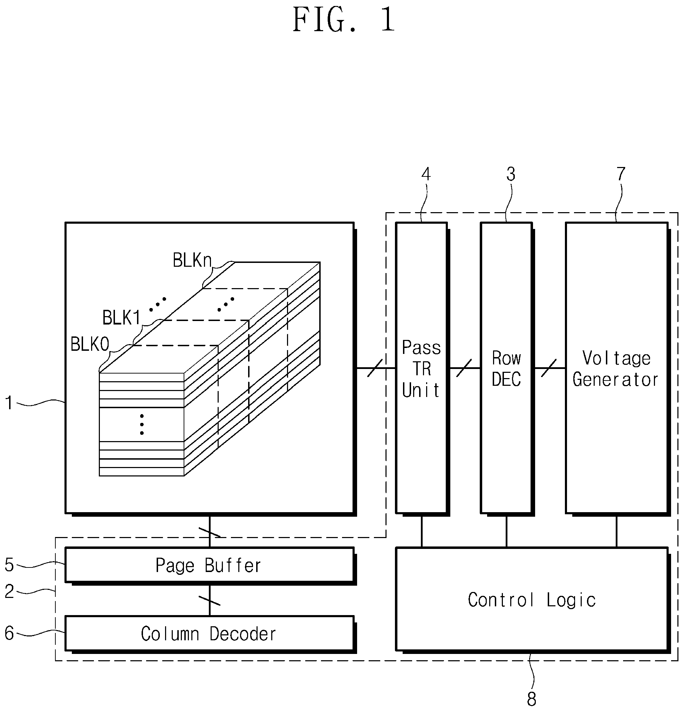

FIG. 1 illustrates a block diagram showing a three-dimensional semiconductor memory device according to an embodiment.

Referring to FIG. 1, a semiconductor memory device may include a memory cell array 1 and a peripheral circuit 2 that controls the memory cell array 1. The peripheral circuit 2 may include a row decoder 3, a pass transistor unit 4, a page buffer 5, a column decoder 6, a voltage generator 7, and a control circuit 8.

The memory cell array 1 may include a plurality of memory blocks BLKO to BLKn (BLK0, BLK1 ... BLKn). Each of the memory blocks BLKO to BLKn may include three-dimensionally arranged memory cells. For example, each of the memory blocks BLKO to BLKn may include structures stacked along a third direction D3 on a plane defined by first and second directions D1 and D2. First direction D1 and second direction D2 may intersect each another. In response to a related block selection signal, the memory blocks BLKO to BLKn may read data from or write data to a selected memory block.

For example, the semiconductor memory device may be a vertical NAND Flash memory device. In the vertical NAND Flash memory device, the memory blocks BLKO to BLKn may include a plurality of NAND-type cell strings.

As another example, in an embodiment, the semiconductor memory device may be a variable resistance memory device. In the variable resistance memory device, the memory blocks BLKO to BLKn may include memory cells correspondingly disposed at intersections between word lines and bit lines. In the embodiment, each of the memory cells may include a resistive memory element. The resistive memory element may include perovskite compounds, transition metal oxide, magnetic materials, ferromagnetic materials, or antiferromagnetic materials.

The row decoder 3 may decode an externally input address to select one of word lines included in the memory blocks BLKO to BLKn.

In accordance with a block selection signal, the pass transistor unit 4 may connect the row decoder 3 to one selected from the memory blocks BLKO to BLKn. The pass transistor unit 4 may include a plurality of pass transistors, where pass transistors may be correspondingly connected to ends of word lines included in each of the memory blocks BLKO to BLKn.

The page buffer 5 may be connected through bit lines to the memory cell array 1 and may read information stored in the memory cells.

The column decoder 6 may decode an externally input address to select one of bit lines. The column decoder 6 may provide a data transmission path between the page buffer 5 and an external device (e.g., a memory controller).

The voltage generator 7 may generate voltages (e.g., program voltage, read voltage, and erase voltage) required for internal operations of the memory cell array 1.

Based on a command signal, an address signal, and a control signal, the control circuit 8 may generate various control signals to program data to the memory cell array 1, to read data from the memory cell array 1, or to erase data stored in the memory cell array 1.

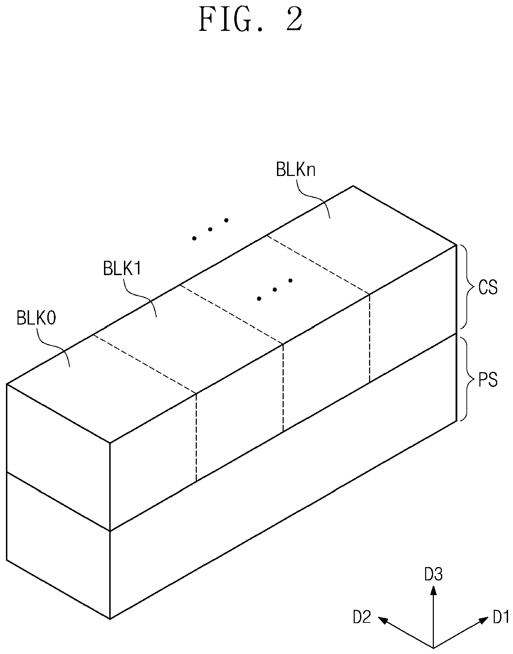

FIG. 2 illustrates a simplified perspective view showing a semiconductor memory device according to an embodiment.

Referring to FIG. 2, a semiconductor memory device according to an embodiment may include a peripheral logic structure PS and a cell array structure CS disposed on the peripheral logic structure PS. When viewed in plan, the cell array structure CS may overlap the peripheral logic structure PS. In some embodiments, the peripheral logic structure PS may include a row decoder, a column decoder, a pass transistor unit, a page buffer, a voltage generator, and a control circuit.

The cell array structure CS may include a plurality of memory blocks BLKO to BLKn each of which is a data erase unit. Each of the memory blocks BLKO to BLKn may include a memory cell array having a three-dimensional structure (or a vertical structure). For example, each of the memory blocks BLKO to BLKn may include a plurality of NAND-type cell strings.

As cell array structure CS is disposed on the peripheral circuit structure PS, the semiconductor memory device according to an embodiment may have an increased cell capacity per unit area.

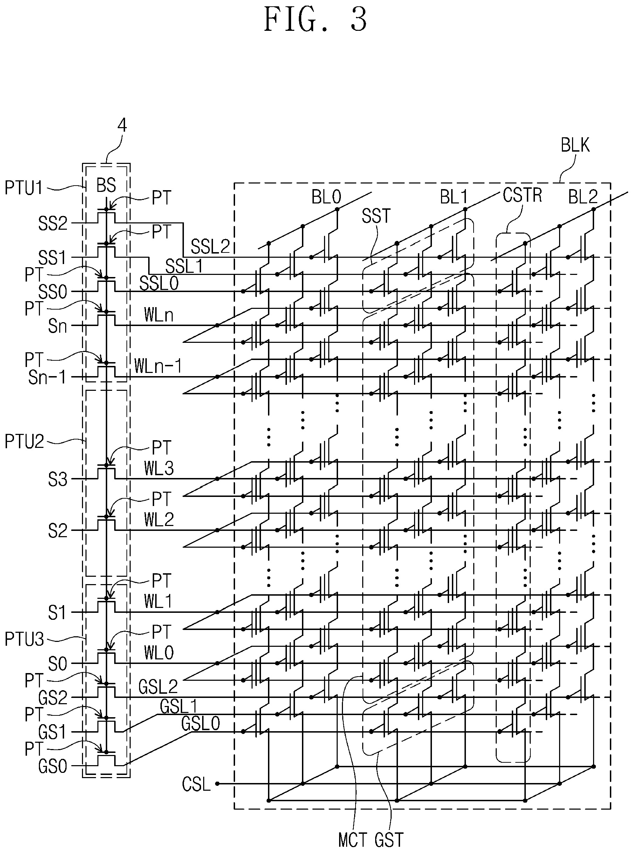

FIG. 3 illustrates a simplified circuit diagram showing a semiconductor memory device according to an embodiment.

Referring to FIG. 3, in a semiconductor memory device according to some embodiments, a pass transistor unit 4 may be connected to each memory block BLK.

The memory block BLK may include a common source line CSL, a plurality of bit lines BL0 to BL2, and a plurality of cell strings CSTR disposed between the common source line CSL and the bit lines BL0 to BL2.

The cell strings CSTR may extend along a third direction D3 on a plane elongated along first and second directions D1 and D2. The cell strings CSTR may be two-dimensionally arranged along the first and second directions D1 and D2 that intersect each other.

The bit lines BL0 to BL2 may be spaced apart from each other in the first direction D 1 and may extend in the second direction D2.

A plurality of cell strings CSTR may be connected in parallel to each of the bit lines BL0 to BL2. A plurality of cell strings CSTR may be connected in common to the common source line CSL. For example, a plurality of cell strings CSTR may be disposed between a plurality of bit lines BL0 to BL2 and one common source line CSL. The common source line CSL may be provided in plural and may be arranged two-dimensionally. The common source lines CSL may, for example, be supplied with the same voltage or may be electrically controlled independently of each other and supplied with different voltages.

According to some embodiments, each of the cell strings CSTR may include a string selection transistor SST, memory cell transistors MCT connected in series, and a ground selection transistor GST. Moreover, each of the memory cell transistors MCT may include a data storage element.

For example, in each of the cell strings CSTR, the string selection transistor SST may be coupled to one of the bit lines BL0 to BL2, and the ground selection transistor GST may be connected to the common source line CSL. The memory cell transistors MCT may be connected in series between the string selection transistor SST and the ground selection transistor GST.

According to some embodiments, the string selection transistor SST may be controlled by one of string selection lines SSLO to SSL2, and the memory cell transistors MCT may be controlled by a plurality of word lines WL0 to WLn. The ground selection transistor GST may be controlled by a corresponding one of ground selection lines GSLO to GLS2. The common source line CSL may be connected in common to sources of the ground selection transistors GST.

The memory cells MCT may include gate electrodes, which are spaced apart at substantially the same distance from the common source lines CSL, connected in common to one of the word lines WL0 to WLn to thereby have an equipotential state.

The ground selection lines GSLO to GSL2 may be located at substantially the same level from the common source lines CSL and may be electrically separated from each other, and the same may be true of the string selection lines SSLO to SSL2.

The word lines WL0 to WLn and the selection lines SSLO to SSL2 and GSLO to GSL2 of each memory block BLK may be connected to the pass transistor unit 4. The pass transistor unit 4 may include a plurality of pass transistors PT each connected to a corresponding one of the word lines WL0 to WLn and the selection lines SSLO to SSL2 and GSLO to GSL2. The pass transistors PT of the pass transistor unit 4 may be controlled by a block selection signal BS provided from a row decoder.

The pass transistors PT may provide drive signals GS0 to GS2, SS0 to SS2, and S0 to Sn to the word lines WL0 to WLn and the selection lines SSLO to SSL2 and GSLO to GLS2 included in a selected one of the memory blocks (see BLKO to BLKn of FIG. 1). According to some embodiments, the word lines WL0 to WLn may be provided with a program voltage, a read voltage, a pass voltage, or a verification voltage, and the selection lines SSLO to SSL2 and GSLO to GSL2 may be provided with a ground voltage, a power voltage, or a threshold voltage.

According to some embodiments, the pass transistor unit 4 may include a plurality of sub-units PTU1, PTU2, and PTU3. The plurality of sub-units PTU1, PTU2, and PTU3 may include a plurality of pass transistors PT. The number of the sub-units PTU1, PTU2, and PTU3 may depend on the number of the word lines WL0 to WLn included in each memory block BLK.

For example, a first sub-unit PTU1 may include pass transistors PT connected to the string selection lines SSLO to SSL2, and may also include pass transistors PT connected to ones WLn and WLn-1 of the word lines WL0 to WLn. A third sub-unit PTU3 may include pass transistors PT connected to the ground selection lines GSLO to GSL2, and may also include pass transistors PT connected to ones WL0 and WL1 of the word lines WL0 to WLn. A second sub-unit PTU2 may include pass transistors PT connected to ones WL2 and WL3 of the word lines WL0 to WLn.

The sub-units PTU1, PTU2, and PTU3 may include the same number of the pass transistors PT, or alternatively may include different numbers of the pass transistors PT.

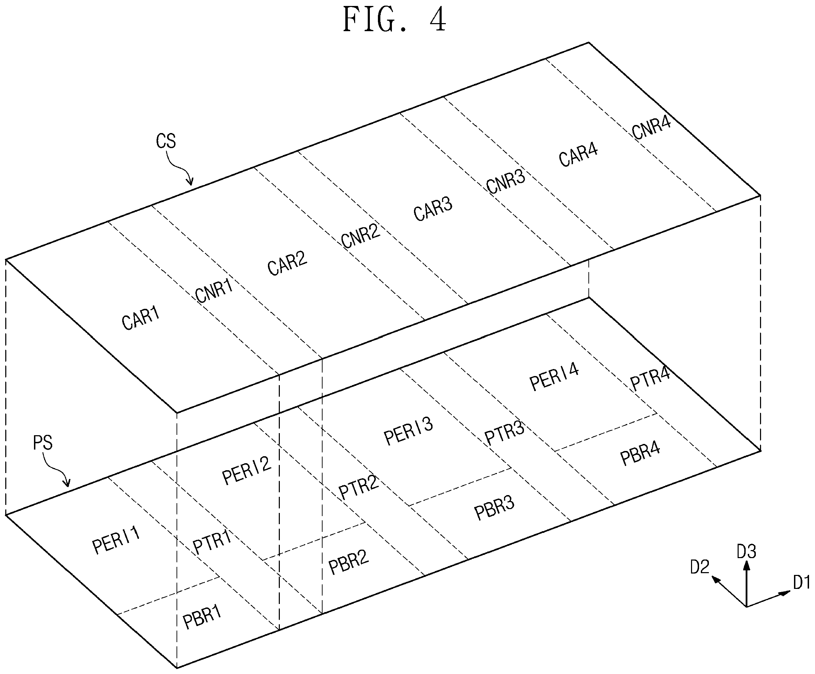

FIG. 4 illustrates a simplified layout showing a semiconductor memory device according to an embodiment.

Referring to FIG. 4, as discussed above with reference to FIG. 2, a cell array structure CS may be disposed on a peripheral logic structure PS.

According to some embodiments, the cell array structure CS may include a plurality of cell array regions CAR1, CAR2, CAR3, and CAR4 and a plurality of connection regions CNR1, CNR2, CNR3, and CNR4. The connection regions CNR1, CNR2, CNR3, and CNR4 may be disposed between the cell array regions CAR1, CAR2, CAR3, and CAR4. For example, the cell array regions CAR1, CAR2, CAR3, and CAR4 and the connection regions CNR1, CNR2, CNR3, and CNR4 may be alternately disposed along a first direction D1. The peripheral circuit structure PS may include a plurality of pass transistor regions PTR1, PTR2, PTR3, and PTR4, a plurality of page buffer regions PBR1, PBR2, PBR3, and PBR4, and a plurality of peripheral circuit regions PERI1, PERI2, PERI3, and PERI4. The pass transistor regions PTR1, PTR2, PTR3, and PTR4 may be disposed correspondingly to the connection regions CNR1, CNR2, CNR3, and CNR4 of the cell array structure CS.

For example, the cell array structure CS may include first, second, third, and fourth cell array regions CAR1, CAR2, CAR3, and CAR4 and first, second, third, and fourth connection regions CNR1, CNR2, CNR3, and CNR4, and the peripheral circuit structure PS may include first, second, third, and fourth pass transistor regions PTR1, PTR2, PTR3, and PTR4, first, second, third, and fourth page buffer regions PBR1, PBR2, PBR3, and PBR4, and first, second, third, and fourth peripheral circuit regions PERI1, PERI2, PERI3, and PERI4.

The first, second, third, and fourth pass transistor regions PTR1, PTR2, PTR3, and PTR4 may respectively correspond to the first, second, third, and fourth connection regions CNR1, CNR2, CNR3, and CNR4. For example, when viewed in plan, the first, second, third, and fourth pass transistor regions PTR1, PTR2, PTR3, and PTR4 may respectively overlap the first, second, third, and fourth connection regions CNR1, CNR2, CNR3, and CNR4. When viewed in plan, the first, second, third, and fourth page buffer regions PBR1, PBR2, PBR3, and PBR4 may overlap first parts of the first, second, third, and fourth cell array regions CAR1, CAR2, CAR3, and CAR4, respectively, and when viewed in plan, the first, second, third, and fourth peripheral circuit regions PERI1, PERI2, PERI3, and PERI4 may overlap second parts of the first, second, third, and fourth cell array regions CAR1, CAR2, CAR3, and CAR4, respectively.

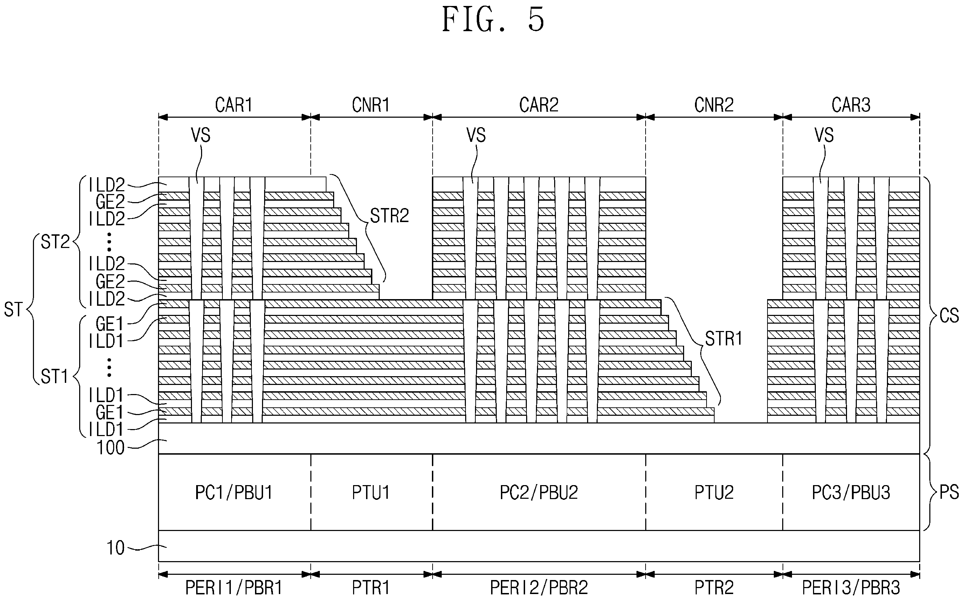

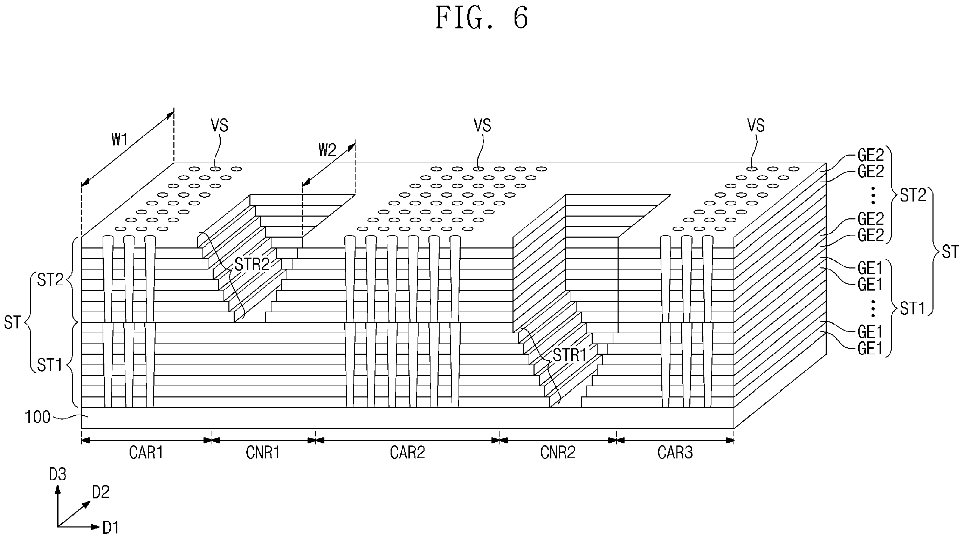

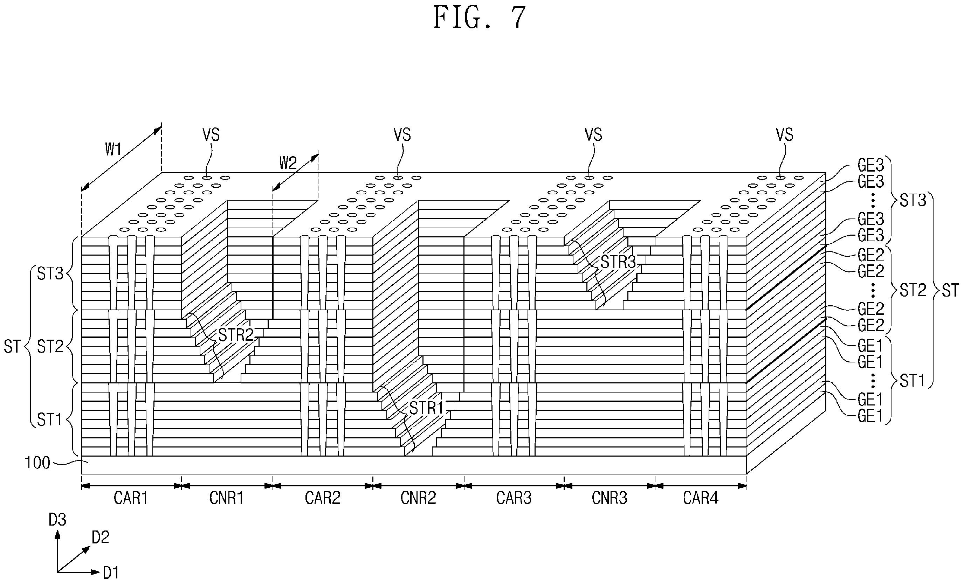

FIG. 5 illustrates a simplified cross-sectional view showing a semiconductor memory device according to an embodiment. FIGS. 6 and 7 illustrate simplified perspective views showing a cell array structure of a semiconductor memory device according to an embodiment.

Referring to FIGS. 5 and 6, a semiconductor memory device according to an embodiment may include a substrate 10, a peripheral circuit structure PS on the substrate 10, and a cell array structure CS on the peripheral circuit structure PS.

The substrate 10 may include a semiconductor material and may be, for example, a silicon substrate, a silicon-germanium substrate, a germanium substrate, or a monocrystalline epitaxial layer grown on a monocrystalline silicon substrate. The substrate 10 may have a top surface. The top surface of the substrate 10 may be parallel to a first direction D1 and a second direction D2 and may be perpendicular to a third direction D3. The first, second, and third directions D1, D2, and D3 may be orthogonal to each other.

As discussed above with reference to FIG. 4, the peripheral circuit structure PS may include a plurality of pass transistor regions PTR1 and PTR2, a plurality of page buffer regions PBR1, PBR2, and PBR3, and a plurality of peripheral circuit regions PERI1, PERI2, and PERI3. The pass transistor regions PTR1 and PTR2 may be provided thereon with sub-units PTU1, PTU2, and PTU3 of a pass transistor unit, and the page buffer regions PBR1, PBR2, and PBR3 may be provided thereon with page buffer circuits PBU1, PBU2, and PBU3. The peripheral circuit regions PERI1, PERI2, and PERI3 may be provided with peripheral circuits PC1, PC2, and PC3 that are separately dispersed thereon.

In some embodiments, the peripheral circuit structure PS may include first and second pass transistor regions PTR1 and PTR2, first, second, and third page buffer regions PBR1, PBR2, and PBR3, and first, second, and third peripheral circuit regions PERI1, PERI2, and PERI3. The first and second pass transistor regions PTR1 and PTR2 may be spaced apart from each other in the first direction D1, and the first pass transistor region PTR1 may be disposed between the first and second page buffer regions PBR1 and PBR2 and between the first and second peripheral circuit regions PERI1 and PERI2. The second pass transistor region PTR2 may be disposed between the second and third page buffer regions PBR2 and PBR3 and between the second and third peripheral circuit regions PERI2 and PERI3.

The first pass transistor region PTR1 may be provided thereon with a first sub-unit PTU1 of the pass transistor unit 4 discussed with reference to FIG. 3, and the second pass transistor region PTR2 may be provided thereon with a second sub-unit PTU2 or a third sub-unit PTU3 of the pass transistor unit 4.

The number of word lines may affect the number of the pass transistor regions PTR1 and PTR2 and the number of sub-units of the pass transistor unit 4.

The cell array structure CS may include a semiconductor layer 100 on the peripheral circuit structure PS, a stack structure ST on the semiconductor layer 100, and vertical structures VS that penetrate the stack structure ST.

As discussed above with reference to FIG. 4, the cell array structure CS may include a plurality of cell array regions CAR1, CAR2, and CAR3 and a plurality of connection regions CNR1 and CNR2 that are alternately arranged along the first direction D1. For example, the cell array structure CS may include first, second, and third cell array regions CAR1, CAR2, and CAR3 and first and second connection regions CNR1 and CNR2, where first connection region CNR1 may be disposed between the first and second cell array regions CAR1 and CAR2, and where second connection region CNR2 may be disposed between the second and third cell array regions CAR2 and CAR3. In some embodiments, when viewed in plan, the first connection region CNR1 may overlap the first pass transistor region PTR1, and when viewed in plan, the second connection region CNR2 may overlap the second pass transistor region PTR2.

The semiconductor layer 100 may be disposed on the peripheral circuit structure PS. The semiconductor layer 100 may include a semiconductor material, such as silicon. The semiconductor layer 100 may include one or more of a semiconductor doped with impurities having a first conductivity type (e.g., n-type) and an intrinsic semiconductor doped with no impurities. The semiconductor layer 100 may include at least one selected from a monocrystalline structure, an amorphous structure, and a polycrystalline structure.

The stack structure ST may include conductive patterns GE1 and GE2 and dielectric layers ILD1 and ILD2 that are alternately stacked along the third direction D3 (which may be referred to as a vertical direction) perpendicular to the first and second directions D1 and D2. The conductive patterns GE1 and GE2 may include, for example, at least one selected from doped semiconductors (e.g., doped silicon), metals (e.g., tungsten, copper, or aluminum), conductive metal nitrides (e.g., titanium nitride or tantalum nitride), and transition metals (e.g., titanium or tantalum). The dielectric layers ILD1 and ILD2 may include one or more of a silicon oxide layer and a low-k dielectric layer.

According to some embodiments, the semiconductor memory device may be a vertical NAND Flash memory device, and in such embodiments, the conductive patterns GE1 and GE2 of the stack structure ST may be used as the ground selection lines GSL0, GSL1, and GSL2, the word lines WL0 to WLn, and the string selection lines SSL0, SSL1, and SSL2 discussed with reference to FIG. 3.

The conductive patterns GE1 and GE2 may be stacked on the semiconductor layer 100 and may have their stepwise structure STR1 and STR2 on the first and second connection regions CNR2 and CNR1. In addition, the conductive patterns GE1 and GE2 may have their pad parts, which define the stepwise structures STR1 and STR2, on the first and second connection regions CNR2 and CNR1. The pad parts of the conductive patterns GE1 and GE2 may be located at positions that are horizontally and vertically different from each other.

The stack structure ST may include a first stack structure ST1 and a second stack structure ST2 on the first stack structure ST1. The first stack structure ST1 may include first conductive patterns GE1 and first dielectric layers ILD1 that are alternately stacked in the third direction D3 on the semiconductor layer 100. The second stack structure ST2 may include second conductive patterns GE2 and second dielectric layers ILD2 that are alternately stacked in the third direction D3 on the first stack structure ST1.

In some embodiments, the stack structure ST may have first and second stepwise structures STR1 and STR2 on the first and second connection regions CNR1 and CNR2, and the first and second stepwise structures STR1 and STR2 may be located at different levels in the D3 direction. That is, the first and second stepwise structures STR1 and STR2 may be located at different vertical levels or different levels from a top surface of the semiconductor layer 100. For example, as shown in FIG. 5, the second stepwise structure STR2 may be farther away from a top surface of the semiconductor layer 100 than the first stepwise structure STR1 is from the top surface of the semiconductor layer 100. For example, the first stepwise structure STR1 may be directly on a top surface of the semiconductor layer 100 and the second stepwise structure STR2 may be spaced apart from the top surface of the semiconductor layer 100. For example, in an embodiment, a distance from a top surface of the semiconductor layer 100 to the second stepwise structure STR2 in the third direction D3 may be greater than a distance from a top surface of the semiconductor layer 100 to a first stepwise structure STR1. The stack structure ST may have a uniform thickness on the first, second, and third cell array regions CAR1, CAR2, and CAR3.

The first stack structure ST1 may have the first stepwise structure STR1 on the second connection region CNR2. The first stepwise structure STR1 may be defined by the pad parts of the first conductive patterns GE1, and may overlap the second pass transistor region PTR2. Alternatively, the first stepwise structure STR1 of the first stack structure ST1 may be provided on the first connection region CNR1, and may overlap the first pass transistor region PTR1.

The second stack structure ST2 may have the second stepwise structure STR2 on the first connection region CNR1. The second stepwise structure STR2 may be defined by the pad parts of the second conductive patterns GE2, and may overlap the first pass transistor region PTR1. Alternatively, the second stepwise structure STR2 of the second stack structure ST2 may be provided on the second connection region CNR2, and may overlap the second pass transistor region PTR2. The second stepwise structure STR2 may be located at a vertical level higher than that of the first stepwise structure STR1.

Referring to FIG. 6, when viewed in the second direction D2, each of the first and second stepwise structures STR1 and STR2 may have a second width W2 less than a first width W1 of the stack structure ST.

The first conductive pattern GE1 on the first, second, and third cell array regions CAR1, CAR2, and CAR3 may be formed of a single layer without being separated by the first stepwise structure STR1. In addition, the second conductive pattern GE2 on the first, second, and third cell array regions CAR1, CAR2, and CAR3 may be formed of a single layer without being separated by the second stepwise structure STR2.

A plurality of vertical structures VS may penetrate the stack structure ST on each of the first, second, and third cell array regions CAR1, CAR2, and CAR3. When viewed in plan, the vertical structures VS may be arranged in a straight fashion or include angles so as to zigzag.

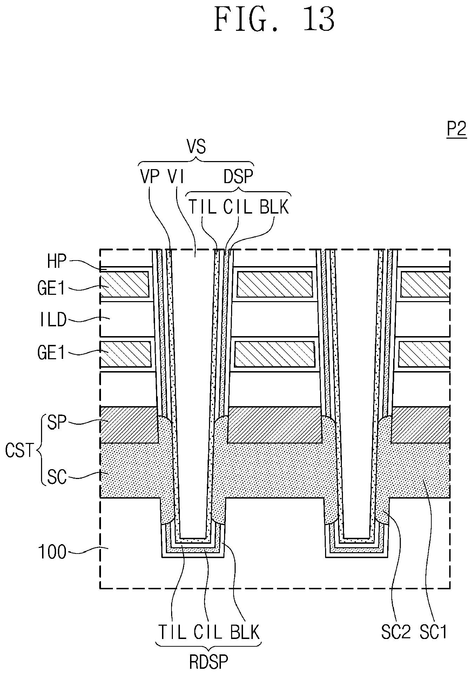

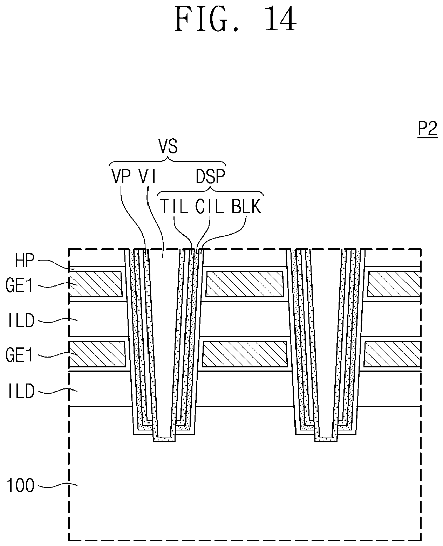

Each of the vertical structures VS may include a first vertical extension that penetrates the first stack structure ST1, a second vertical extension that penetrates the second stack structure ST2, and an expansion between the first and second vertical extensions. The vertical structure VS may have a diameter that abruptly increases at the expansion. The vertical structure VS will be further discussed in detail with reference to FIGS. 13 and 14.

According to the embodiment shown in FIG. 7, the cell array structure CS may include first, second, third, and fourth cell array regions CAR1, CAR2, CAR3, and CAR4 and first, second, and third connection regions CNR1, CNR2, and CNR3 that are alternately arranged along the first direction D 1.

The stack structure ST on the semiconductor layer 100 may include first, second, and third stack structures ST1, ST2, and ST3 that are sequentially stacked along the third direction D3. The stack structure ST may extend in the first direction D1, and may have a uniform thickness on the first to fourth cell array regions CAR1 to CAR4.

As discussed above, the first stack structure ST1 may include first conductive patterns GE1 that are stacked along the third direction D3 with dielectric layers therebetween, and the second stack structure ST2 may include second conductive patterns GE2 that are stacked along the third direction D3 with dielectric layers therebetween. The third stack structure ST3 may include third conductive patterns GE3 that are stacked on the second stack structure ST2 with dielectric layers therebetween.

The first, second, and third stack structures ST1, ST2, and ST3 may have first, second, and third stepwise structures STR1, STR2, and STR3 on the first, second, and third connection regions CNR1, CNR2, and CNR3. The first, second, and third stepwise structures STR1, STR2, and STR3 of the first, second, and third stack structures ST1, ST2, and ST3 may be located at different levels from a top surface of the semiconductor layer 100. Each of the first, second, and third stepwise structures STR1, STR2, and STR3 may overlap one of the first, second, and third pass transistor regions PTR1, PTR2, and PTR3.

For example, the first stack structure ST1 may have the first stepwise structure STR1 on the second connection region CNR2, the second stack structure ST2 may have the second stepwise structure STR2 on the first connection region CNR1, and the third stack structure ST3 may have the third stepwise structure STR3 on the third connection region CNR3. The second stepwise structure STR2 may be located at a vertical level higher than that of the first stepwise structure STR1, and the third stepwise structure STR3 may be located at a vertical level higher than that of the second stepwise structure STR2.

As described, an example embodiment includes the first, second, and third stack structures ST1, ST2, and ST3, but embodiments are not limited thereto and an increase in integration of the semiconductor memory device may cause an increase in the number of stack structures.

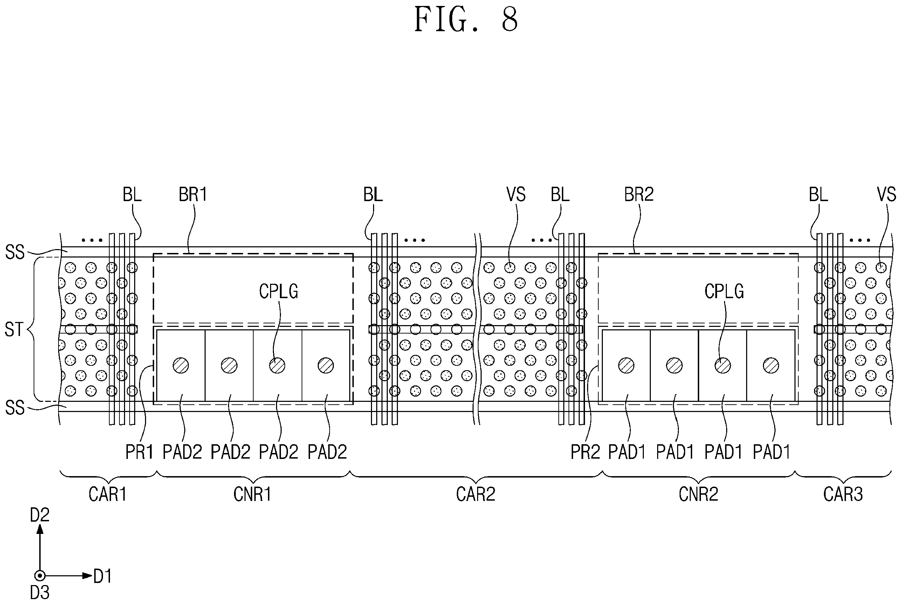

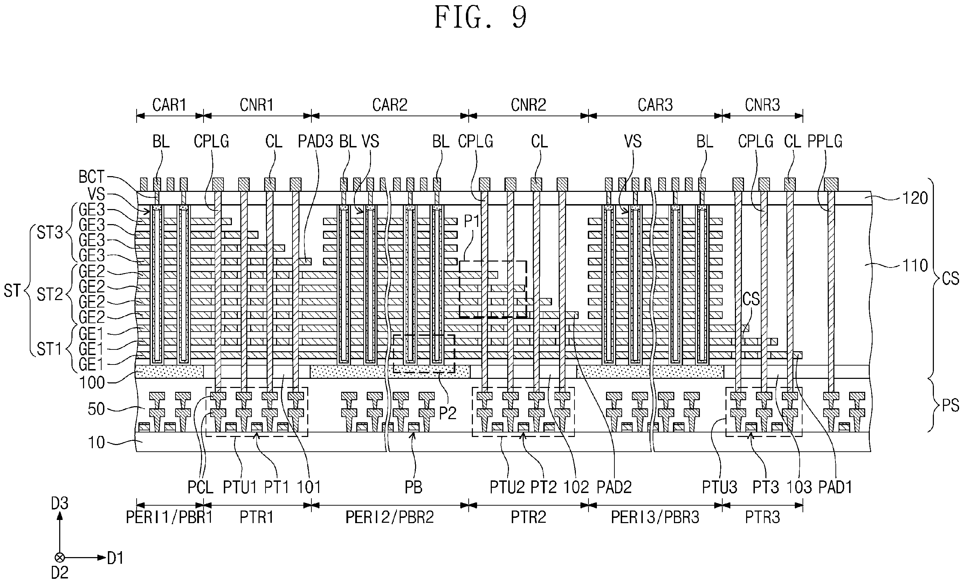

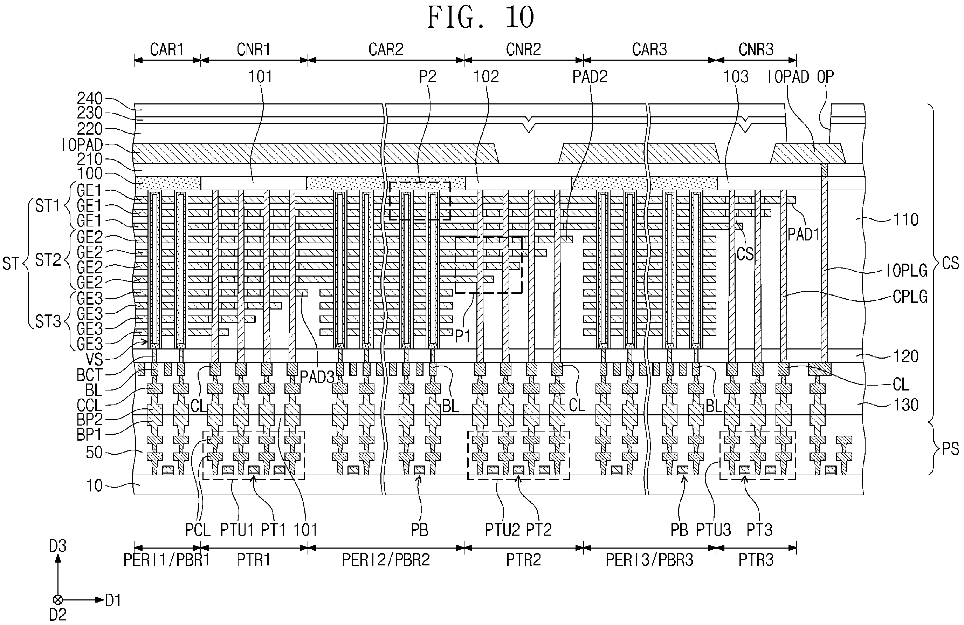

FIG. 8 illustrates a simplified layout showing a semiconductor memory device according to an embodiment. FIGS. 9 and 10 illustrate cross-sectional views showing a semiconductor memory device according an embodiment.

Referring to FIGS. 8 and 9, as discussed above, a semiconductor memory device according to an embodiment may include a substrate 10, a peripheral circuit structure PS on the substrate 10, and a cell array structure CS on the peripheral circuit structure PS.

The peripheral circuit structure PS may include peripheral circuits (e.g., one or more of row and column decoders, a page buffer, and a control circuit) integrated on a surface of the substrate 10, and a lower dielectric layer 50 on, and in an embodiment, covering the peripheral circuits. In an embodiment, the peripheral circuits may be disposed throughout any part of the surface of the substrate 10 and may be integrated on an entire surface of the substrate 10.

The substrate 10 may be a silicon substrate. As discussed above with reference to FIG. 4, the substrate 10 may include a plurality of pass transistor regions PTR1, PTR2, and PTR3, a plurality of page buffer regions PBR1, PBR2, and PBR3, and a plurality of peripheral circuit regions PERI1, PERI2, and PERI3.

The peripheral circuits may include NMOS and PMOS transistors. Peripheral circuit lines PCL may be electrically connected through peripheral contact plugs to the peripheral circuits.

For example, first, second, and third page buffer regions PBR1, PBR2, and PBR3 may be spaced apart from each other in a first direction D1. The first pass transistor region PTR1 may be disposed between the first and second page buffer regions PBR1 and PBR2, and the second pass transistor region PTR2 may be disposed between the second and third page buffer regions PBR2 and PBR3. The third pass transistor region PTR3 may be disposed spaced apart in the first direction D 1 from the second pass transistor region PTR2.

On the first pass transistor region PTR1, the substrate 10 may be provided thereon with a first sub-unit PTU1 that includes a plurality of first pass transistors PT1. On the second pass transistor region PTR2, the substrate 10 may be provided thereon with a second sub-unit PTU2 that includes a plurality of second pass transistors PT2. On the third pass transistor region PTR3, the substrate 10 may be provided thereon with a third sub-unit PTU3 that includes a plurality of third pass transistors PT3.

The first, second, and third page buffer regions PBR1, PBR2, and PBR3 may include page buffer circuits PB connected to bit lines BL.

The first, second, and third peripheral circuit regions PERI1, PERI2, and PERI3 may include peripheral circuits that are separately disposed to control the page buffer circuits PB and the pass transistors PT1, PT2, and PT3.

The lower dielectric layer 50 may be provided on the entire surface of the substrate 10. On the substrate 10, the lower dielectric layer 50 may cover the pass transistors PT1, PT2, and PT3, the page buffer circuits PB, the peripheral circuits, and the peripheral circuit lines PCL. The peripheral circuit lines PCL may be electrically connected to the peripheral circuits.

The lower dielectric layer 50 may include a plurality of stacked dielectric layers. For example, the lower dielectric layer 50 may include one or more of a silicon oxide layer, a silicon nitride layer, a silicon oxynitride layer, and a low-k dielectric layer.

The cell array structure CS may include a semiconductor layer 100, a stack structure ST, vertical structures VS, bit lines BL, connection lines CL, cell contact plugs CPLG, and peripheral contact plugs PPLG.

As discussed above, the cell array structure CS of an embodiment may include a plurality of cell array regions CAR1, CAR2, and CAR3 and a plurality of connection regions CNR1, CNR2, and CNR3 that are alternately arranged along the first direction D1. As discussed above, the connection regions CNR1, CNR2, and CNR3 may correspondingly overlap the pass transistor regions PTR1, PTR2, and PTR3 of the peripheral circuit structure PS.

In addition, according to some embodiments, as shown in FIG. 8, the connection regions CNR1 and CNR2 may correspondingly include pad regions PR1 and PR2 and bridge regions BR1 and BR2 in a second direction D2 that intersects the first direction D1.

As discussed above, the semiconductor layer 100 may be disposed on a top surface of the lower dielectric layer 50. The semiconductor layer 100 may have an opening on each of the first, second, and third connection regions CNR1, CNR2, and CNR3, and the openings may be filled with dielectric patterns 101, 102, and 103. The dielectric patterns 101, 102, and 103 may contact the lower dielectric layer 50, and may have a top surface substantially coplanar with that of the semiconductor layer 100.

On the cell array structure CS, a plurality of stack structures ST may be provided on the semiconductor layer 100. When viewed in plan as shown in FIG. 5, the plurality of stack structures ST may extend in the first direction D1 and may be spaced apart from each other in the second direction D2. For convenience of description, the following will explain a single stack structure ST, and the explanation may be applicable to other stack structures ST which may be substantially similar or identical.

The stack structure ST may be disposed between separation structures SS that extend in parallel along the first direction D1 and are spaced apart from each other in the second direction D2. The separation structures SS may be provided on the semiconductor layer 100. The separation structures SS may include a dielectric material, such as silicon oxide.

As discussed above, the stack structure ST may include conductive patterns GE1, GE2, and GE3 and dielectric layers that are alternately stacked along a third direction D3 (or vertical direction).

In some embodiments, the stack structure ST may include a first stack structure ST1, a second stack structure ST2 on the first stack structure ST1, and a third stack structure ST3 on the second stack structure ST2. The first stack structure ST1 may be disposed between the second stack structure ST2 and the peripheral circuit structure PS. The first stack structure ST1 may include dielectric layers and first conductive patterns GE1 that are alternately stacked, and the second stack structure ST2 may include dielectric layers and second conductive patterns GE2 that are alternately stacked. The third stack structure ST3 may include dielectric layers and third conductive patterns GE3 that are alternately stacked.

The conductive patterns GE1, GE2, and GE3 may include pad parts PAD1, PAD2, and PAD3 on the connection regions CNR1, CNR2, and CNR3. The pad parts PAD1, PAD2, and PAD3 of the conductive patterns GE1, GE2, and GE3 may be located at positions that are horizontally and vertically different from each other.

For example, the first conductive patterns GE1 may include first pad parts PAD1 on the third connection region CNR3, and the first pad parts PAD1 may define a first stepwise structure. The second conductive patterns GE2 may include second pad parts PAD2 on the second connection region CNR2, and the second pad parts PAD2 may define a second stepwise structure. The third conductive patterns GE3 may include third pad parts PAD3 on the first connection region CNR1, and the third pad parts PAD3 may define a third stepwise structure. The first, second, and third stepwise structures of the stack structure ST may be located at different vertical levels from a top surface of the substrate 10.

For example, the first pad parts PAD1 of the first conductive patterns GE1 may be disposed on a first pad region PR1 discussed with reference to FIG. 8, and the second pad parts PAD2 of the second conductive patterns GE2 may be disposed on a second pad region PR2 discussed with reference to FIG. 8.

Moreover, the stack structure ST may have substantially the same thickness on first and second bridge regions BR1 and BR2 and the cell array regions CAR1, CAR2, and CAR3 .

The stack structure ST may be provided thereon with a planarized dielectric layer 110 that covers the pad parts PAD1, PAD2, and PAD3 having a stepwise structure. The planarized dielectric layer 110 may have a substantially flat top surface. The planarized dielectric layer 110 may include one dielectric layer or a plurality of stacked dielectric layers. The planarized dielectric layer 110 may have substantially flat top and bottom surfaces. The top surface of the planarized dielectric layer 110 may be substantially coplanar with a top surface of an uppermost dielectric layer included in the stack structure ST, and the bottom surface of the planarized dielectric layer 110 may be substantially coplanar with a bottom surface of a lowermost dielectric layer included in the stack structure ST.

A plurality of vertical structures VS may penetrate the stack structure ST on each of the first, second, and third cell array regions CAR1, CAR2, and CAR3. When viewed in plan, the vertical structures VS may be arranged along one direction in a straight fashion or may include angles so as to zigzag.

The planarized dielectric layer 110 may be provided thereon with an interlayer dielectric layer 120 that covers top surfaces of the vertical structures VS.

The cell contact plugs CPLG may penetrate the interlayer dielectric layer 120 and the planarized dielectric layer 110 to be coupled to the pad parts PAD1, PAD2, and PAD3 of the conductive patterns GE1, GE2, and GE3. The cell contact plugs CPLG may have substantially the same vertical length. Alternatively, the cell contact plugs CPLG may have different vertical lengths.

The cell contact plugs CPLG may have their top surfaces substantially coplanar with each other. The connection lines CL may be disposed on the interlayer dielectric layer 120 of the first, second, and third connection regions CNR1, CNR2, and CNR3, and may be coupled to the cell contact plugs CPLG.

On the first connection region CNR1, the cell contact plugs CPLG may correspondingly penetrate the third pad parts PAD3 of the third conductive patterns GE3 to correspondingly come into connection with the first pass transistors PT1 of the first sub-unit PTU1.

On the second connection region CNR2, the cell contact plugs CPLG may correspondingly penetrate the second pad parts PAD2 of the second conductive patterns GE2 to correspondingly come into connection with the second pass transistors PT2 of the second sub-unit PTU2.

On the third connection region CNR3, the cell contact plugs CPLG may correspondingly penetrate the first pad parts PAD1 of the first conductive patterns GE1 to correspondingly come into connection with the third pass transistors PT3 of the third sub-unit PTU3.

The bit lines BL may be disposed on the interlayer dielectric layer 120 on the cell array regions CAR1, CAR2, and CAR3, and the connection lines CL may be disposed on the interlayer dielectric layer 120 on the connection regions CNR1, CNR2, and CNR3.

The bit lines BL may extend in the second direction D2 and cross the stack structure ST. The bit lines BL may be electrically connected through bit-line contacts BCT to the vertical structures VS.

The connection lines CL may be correspondingly connected to the cell contact plugs CPLG on the connection regions CNR1, CNR2, and CNR3.

The peripheral contact plugs PPLG may be laterally spaced apart from the stack structure ST to penetrate the planarized dielectric layer 110 and the interlayer dielectric layer 120. The peripheral contact plugs PPLG may be electrically connected to the peripheral circuit lines PCL.

Each of the cell contact plugs CPLG and the peripheral contact plugs PPLG may include a barrier layer including conductive metal nitride (e.g., titanium nitride or tantalum nitride) and a metal layer including metal (e.g., tungsten, titanium, or tantalum).

Referring to FIGS. 8 and 10, a chip-to-chip (C2C) structure may be given to a semiconductor memory device according to some embodiments. The chip-to-chip (C2C) structure may be fabricated by forming on a first wafer a lower chip including a peripheral circuit structure PS; forming, on a second wafer different from the first wafer, an upper chip including a cell array structure CS; and then using a bonding method to connect the upper chip and the lower chip to each other. For example, the bonding method may include electrically connecting a bonding metal formed on an uppermost metal layer of the upper chip to a bonding metal formed on an uppermost metal layer of the lower chip. For example, when the bonding metal is formed of copper (Cu), the bonding method may be a Cu-to-Cu bonding method, and the bonding metal may be formed of aluminum (Al) or tungsten (W).

In such a method according to an embodiment, in which the peripheral circuit structure PS and the cell array structure CS are each fabricated and then combined with each other, may be employed to prevent peripheral circuits from damage due to various heat treatment processes, and thus it may be possible to improve reliability and electrical properties of the three-dimensional semiconductor memory device.

The peripheral circuit structure PS may be integrated on an entire surface of the substrate 10, and may include peripheral circuit that control a memory cell array, peripheral circuit lines PCL electrically connected to the peripheral circuits, first bonding pads BP1 electrically connected to the peripheral circuit lines PCL, and a lower dielectric layer 50 that surrounds the peripheral circuits, the peripheral circuit lines PCL, and the first bonding pads BP1.

As discussed above, the peripheral circuit structure PS may include a plurality of pass transistor regions PTR1, PTR2, and PTR3, a plurality of page buffer regions PBR1, PBR2, and PBR3, and a plurality of peripheral circuit regions PERI1, PERI2, and PERI3. The pass transistor regions PTR1, PTR2, and PTR3 may include pass transistors PT1, PT2, and PT3, and the page buffer regions PBR1, PBR2, and PBR3 may include page buffer circuits PB. The peripheral circuit regions PERI1, PERI2, and PERI3 may include a row decoder, a column decoder, and a control circuit. The lower dielectric layer 50 may include a single dielectric layer or a plurality of stacked dielectric layers.

The first bonding pads BP1 may be disposed in an uppermost lower dielectric layer 50. The lower dielectric layer 50 may not cover top surfaces of the first bonding pads BP1. The uppermost lower dielectric layer 50 may have a top surface substantially coplanar with those of the first bonding pads BP1. The first bonding pads BP1 may be electrically connected through the peripheral circuit lines PCL to the peripheral circuits.

The cell array structure CS may be provided on the peripheral circuit structure PS. The cell array structure CS may include a semiconductor layer 100, a stack structure ST, vertical structures VS, bit lines BL, connection lines CL, the cell contact plugs CPLG, input/output contact plugs IOPLG, input/output pads IOPAD, and second bonding pads BP2.

Different from the embodiment of FIG. 9, in this embodiment, the stack structure ST may have an inverse stepwise structure on each of connection regions CNR1, CNR2, and CNR3. The stack structure ST may have a substantially uniform thickness on cell array regions CAR1, CAR2, and CAR3. In an embodiment, the thickness of the stack structure ST may be uniform on each of the cell array regions CAR1, CAR2, and CAR3 and each of the cell array regions CAR1, CAR2 and CAR3 may have stack structures ST with the same uniform thickness.

As discussed above, the vertical structures VS may penetrate the stack structure ST on each of the cell array regions CAR1, CAR2, and CAR3.

On each of the connection regions CNR1, CNR2, and CNR3, the cell contact plugs CPLG may be correspondingly coupled to pad parts PAD1, PAD2, and PAD3 of conductive patterns GE1, GE2, and GE3. The cell contact plugs CPLG may penetrate an interlayer dielectric layer 120 and a planarized dielectric layer 110 to come into contact with dielectric patterns 101, 102, and 103.

The input/output contact plugs IOPLG may penetrate interlayer dielectric layers 120 and 130 and the planarized dielectric layer 110, and may be coupled through connection lines CL to the second bonding pads BP2. Each of the interlayer dielectric layers 120 and 130 may include a single dielectric layer or a plurality of dielectric layers such as a plurality of stacked dielectric layers.

The second bonding pads BP2 may be provided in an uppermost interlayer dielectric layer 130 on the cell array structure CS. The second bonding pads BP2 may be electrically connected to the bit lines BL and the connection lines CL. An uppermost interlayer dielectric layer 130 may have a surface in direct contact with that of the uppermost lower dielectric layer 50 included in the peripheral circuit structure PS.

A bonding method may be employed to electrically and physically connect the second bonding pads BP2 to the first bonding pads BP1. For example, the second bonding pads BP2 may be in direct contact with the first bonding pads BP1. The second bonding pads BP2 may have substantially the same shape, width, and area as those of the first bonding pads BP1.

The second bonding pads BP2 may include the same metallic material as that of the first bonding pads BP1. The second bonding pads BP2 may be formed of, for example, at least one of aluminum, copper, or tungsten.

A surface dielectric layer 210 may cover a bottom surface of the semiconductor layer 100. The input/output pads IOPAD may be disposed on the surface dielectric layer 210. A capping dielectric layer 220 may be disposed on the surface dielectric layer 210, and the capping dielectric layer 220 may cover the input/output pads IOPAD.

A protection layer 230 and a passivation layer 240 may be sequentially formed on an entire surface of the capping dielectric layer 220. The protection layer 230 may include, for example, a silicon nitride layer or a silicon oxynitride layer. The passivation layer 240 may include a polyimide-based material, such as photosensitive polyimide (PSPI).

The protection layer 230 and the passivation layer 240 may have an opening OP that expose a portion of the input/output pad IOPAD.

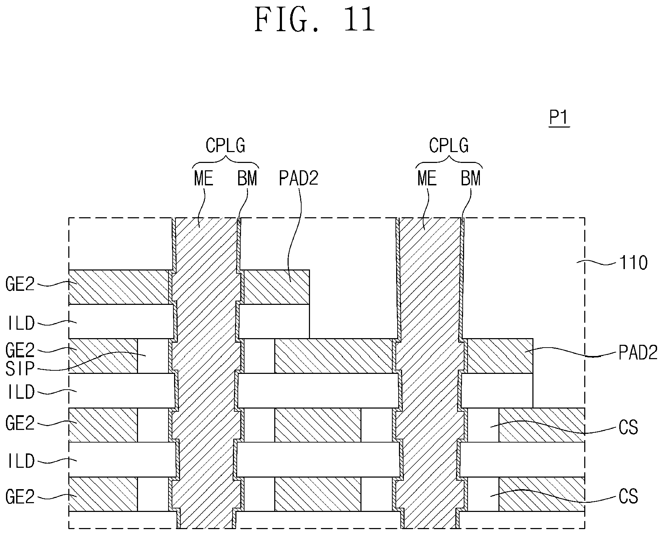

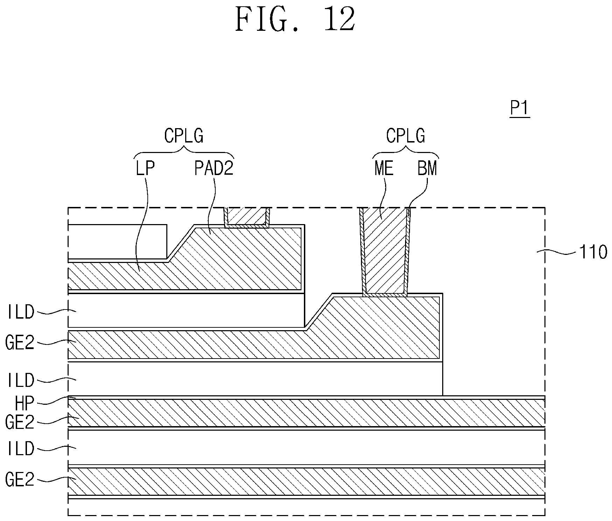

FIGS. 11 and 12 illustrate cross-sectional views of section P1 of FIGS. 9 and 10, showing a semiconductor memory device according to an embodiment. FIGS. 13 and 14 illustrate cross-sectional views of section P2 of FIGS. 9 and 10, showing a semiconductor memory device according to an embodiment. The following description related to the conductive pattern GE2 will be identically or similarly to other conductive patterns GE1 and GE3.

Referring to FIGS. 9, 10, and 11, the cell contact plugs CPLG may be one-to-one electrically connected to the conductive patterns GE2, and each of the cell contact plugs CPLG may penetrate the pad part PAD2 of a corresponding conductive pattern GE2. The cell contact plugs CPLG may be correspondingly in contact with sidewalls of the conductive patterns GE2. Sidewall dielectric patterns SIP may be correspondingly interposed between the cell contact plugs CPLG and the conductive patterns GE2 stacked below the pad parts PAD2 to which the cell contact plugs CPLG are electrically connected.

Referring to FIGS. 9, 10, and 12, each of the conductive patterns GE2 may include a line part LP on the cell array region CAR2 and a pad part PAD2 on the connection region CNR2.

The line part LP may have a first thickness, and the pad part PAD2 may have a second thickness greater than the first thickness. A bottom surface of the line part LP may be coplanar with that of the pad part PAD2. A top surface of the pad part PAD2 may be located at a higher level than that of a top surface of the line part LP. The top surface of the pad part PAD2 may be in contact with the cell contact plug CPLG that penetrates the planarized dielectric layer 110.

A horizontal dielectric pattern HP may conformally be disposed on and cover top and bottom surfaces of the conductive pattern GE2 and may also conformally be disposed on and cover sidewalls of the conductive patterns GE2, where sidewalls are adjacent to the vertical structures VS. The horizontal dielectric pattern HP may include a high-k dielectric layer, such as an aluminum oxide layer or a hafnium oxide layer.

Referring to FIG. 13, the cell array structure CS according to the semiconductor memory device may further include a source structure CST between the stack structure ST and the semiconductor layer 100.

The source structure CST may include a source conductive pattern SC on the semiconductor layer 100 and a support conductive pattern SP on the source conductive pattern SC. The source structure CST may be parallel to a top surface of the semiconductor layer 100 and may extend in the first direction D1 along the stack structure ST.

Each of the vertical structures VS may include a vertical semiconductor pattern VP and a data storage pattern DSP that surrounds a sidewall of the vertical semiconductor pattern VP.

For example, the vertical semiconductor pattern VP may have a macaroni shape or a pipe shape with a closed bottom end. The vertical semiconductor pattern VP may be shaped like U, and a vertical dielectric pattern VI may fill an inside of the vertical semiconductor pattern VP. The vertical semiconductor pattern VP may include a semiconductor material, such as silicon (Si), germanium (Ge), or a mixture thereof. The vertical structures VS including a semiconductor material may serve as channels of the string selection transistors SST, the memory cell transistors MCT, and the ground selection transistors GST discussed with reference to FIG. 3. The vertical semiconductor pattern VP may have a bottom surface at a lower level than that of a bottom surface of the source conductive pattern SC.

The vertical semiconductor pattern VP may have a sidewall a portion of which is in contact with the source conductive pattern SC. For example, the source conductive pattern SC may include a horizontal part SC1 parallel to the stack structure ST between the support conductive pattern SP and the semiconductor layer 100, and may also include a sidewall part SC2 that contacts and surrounds a portion of the sidewall of the vertical semiconductor pattern VP. The source conductive pattern SC may be configured such that a top surface of the horizontal part SC1 may be in contact with a bottom surface of the support conductive pattern SP, and such that a bottom surface of the horizontal part SC1 may be in contact with the top surface of the semiconductor layer 100. The sidewall part SC2 of the source conductive pattern SC may vertically protrude from the horizontal part SC1 of the source conductive pattern SC to come into partial contact with a sidewall of the support conductive pattern SP. The sidewall part SC2 of the source conductive pattern SC may have a thickness in the third direction D3 greater than that of the horizontal part SC1 of the source conductive pattern SC.

The data storage pattern DSP may extend in the third direction D3 and may surround the sidewall of the vertical semiconductor pattern VP. The data storage pattern DSP may have a macaroni shape or a pipe shape with open top and bottom ends. A bottom surface of the data storage pattern DSP may be located at a level between those of top and bottom surfaces of the support conductive pattern SP. The data storage pattern DSP may be formed of a single thin layer or a plurality of thin layers. In some embodiments, the data storage pattern DSP may include a tunnel dielectric layer TIL, a charge storage layer CIL, and a blocking dielectric layer BLK that are sequentially stacked on the sidewall of the vertical semiconductor pattern VP, where layers TIL, CIL, and BLK constitute a data storage layer of a NAND Flash memory device. For example, the charge storage layer CIL may be a trap dielectric layer, a floating gate electrode, or a dielectric layer including conductive nano-dots.

In addition, the semiconductor layer 100 may be provided therein with a dummy data storage pattern RDSP vertically spaced apart from the data storage pattern DSP. The dummy data storage pattern RDSP may have a thin film structure the same as that of the data storage pattern DSP.

According to the embodiment shown in FIG. 14, each of the vertical structures VS may penetrate the stack structure ST to come into connection with the semiconductor layer 100. For example, each of the vertical structures VS may include a data storage pattern DSP, a vertical semiconductor pattern VP, and a vertical dielectric pattern VI. The vertical semiconductor pattern VP may be in direct contact with the semiconductor layer 100, and may have a "U" shape or a pipe shape whose bottom end is closed.

The data storage pattern DSP may have a macaroni shape or a pipe shape which extends in the third direction D3 and having open top and bottom ends. The data storage pattern DSP may surround the sidewall of the vertical semiconductor pattern VP. As discussed above, the data storage pattern DSP may include a tunnel dielectric layer TIL, a charge storage layer CIL, and a blocking dielectric layer BLK, which constitute a data storage layer of a NAND Flash memory device.

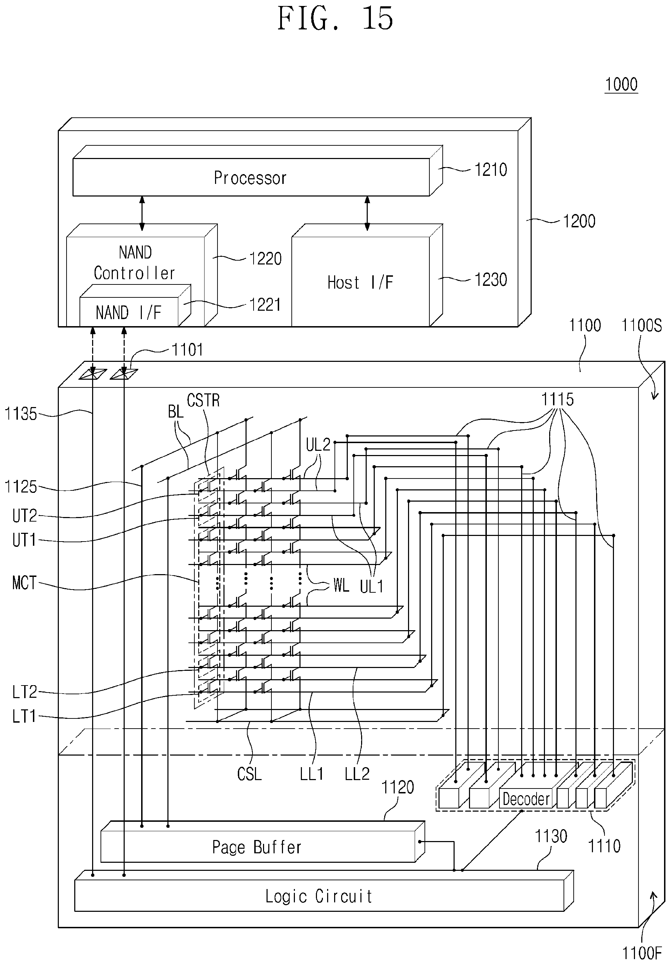

FIG. 15 illustrates a simplified schematic diagram showing an electronic system including a semiconductor memory device according to an embodiment.

Referring to FIG. 15, an electronic system 1000 according to some embodiments may include a semiconductor memory device 1100 and a controller 1200 electrically connected to the semiconductor memory device 1100. The electronic system 1000 may be a storage device that includes a single or a plurality of semiconductor memory devices 1100, or may be an electronic device that includes the storage device. For example, the electronic system 1000 may be a solid state drive (SSD) device, a universal serial bus (USB), a computing system, a medical apparatus, or a communication apparatus, each of which includes a single or a plurality of semiconductor memory devices 1100.

The semiconductor memory device 1100 may be a nonvolatile memory device, such as a NAND Flash memory device. The semiconductor memory device 1100 may include a first structure 1100F and a second structure 1100S on the first structure 1100F. In some embodiments, the first structure 1100F may be disposed on a side of the second structure 1100S.

The first structure 1100F may be a peripheral circuit structure that includes a decoder circuit 1110, a page buffer 1120, and a logic circuit 1130. The second structure 1100S may be a memory cell structure that includes bit lines BL, a common source line CSL, word lines WL, first and second gate upper lines UL1 and UL2, first and second gate lower lines LL1 and LL2, and memory cell strings CSTR between the bit line BL and the common source line CSL.

For the second structure 1100S, each of the memory cell strings CSTR may include lower transistors LT1 and LT2 adjacent to the common source line CSL, upper transistors UT1 and UT2 adjacent to the bit line BL, and memory cell transistors MCT disposed between the lower transistors LT1 and LT2 and the upper transistors UT1 and UT2. The number of the lower transistors LT1 and LT2 and of the upper transistors UT1 and UT2 may be vary in accordance with various embodiments.

In some embodiments, the upper transistors UT1 and UT2 may include a string selection transistor, and the lower transistors LT1 and LT2 may include a ground selection transistor. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In some embodiments, the lower transistors LT1 and LT2 may include a lower erase control transistor LT1 and a ground selection transistor LT2 that are connected in series. The upper transistors UT1 and UT2 may include a string selection transistor UT1 and an upper erase control transistor UT2 that are connected in series. One or both of the lower and upper erase control transistors LT1 and UT1 may be employed to perform an erase operation in which a gate induced drain leakage (GIDL) phenomenon is used to erase data stored in the memory cell transistors MCT.

The common source line CSL, the first and second gate lower lines LL1 and LL2, the word lines WL, and the first and second gate upper lines UL1 and UL2 may be electrically connected to the decoder circuit 1110 through first connection lines 1115 that extend from the first structure 1100F toward the second structure 1100S. The bit lines BL may be electrically connected to the page buffer 1120 through second connection lines 1125 that extend from the first structure 1100F toward the second structure 1100S.

For the first structure 1100F, the decoder circuit 1110 and the page buffer 1120 may perform a control operation to at least one selection memory cell transistor among the plurality of memory cell transistors MCT. The logic circuit 1130 may control the decoder circuit 1110 and the page buffer 1120. The semiconductor memory device 1100 may communicate with the controller 1200 through an input/output pad 1101 electrically connected to the logic circuit 1130. The input/output pad 1101 may be electrically connected to the logic circuit 1130 through an input/output connection line 1135 that extends from the first structure 1100F toward the second structure 1100S.

Although not shown, the first structure 1100F may include a voltage generator. The voltage generator may produce program voltages, read voltages, pass voltages, and verification voltages that are required for operating the memory cell strings CSTR. The program voltage may be relatively higher (e.g., about 20 V to about 40 V) than the read voltage, the pass voltage, and the verification voltage.

In some embodiments, the first structure 1100F may include high-voltage transistors and low-voltage transistors. The decoder circuit 1110 may include pass transistors connected to the word lines WL of the memory cell strings CSTR. The pass transistors may include high-voltage transistors capable of withstanding high voltages such as program voltages applied to the word lines WL in a program operation. The page buffer 1120 may also include high-voltage transistors capable of withstanding high voltages.

The controller 1200 may include a processor 1210, a NAND controller 1220, and a host interface 1230. In some embodiments, the electronic system 1000 may include a plurality of semiconductor memory devices 1100, and in this case, the controller 1200 may control the plurality of semiconductor memory devices 1100.

The processor 1210 may control an overall operation of the electronic system 1000 that includes the controller 1200. The processor 1210 may operate based on predetermined firmware, and may control the NAND controller 1220 to access the semiconductor memory device 1100. The NAND controller 1220 may include a NAND interface 1221 that processes communication with the semiconductor memory device 1100. The NAND interface 1221 may be used to transfer therethrough a control command to control the semiconductor memory device 1100, data intended to be written on the memory cell transistors MCT of the semiconductor memory device 1100, and/or data intended to be read from the memory cell transistors MCT of the semiconductor memory device 1100. The host interface 1230 may provide the electronic system 1000 with communication with an external host. When a control command is received through the host interface 1230 from an external host, the semiconductor memory device 1100 may be controlled by the processor 1210 in response to the control command.

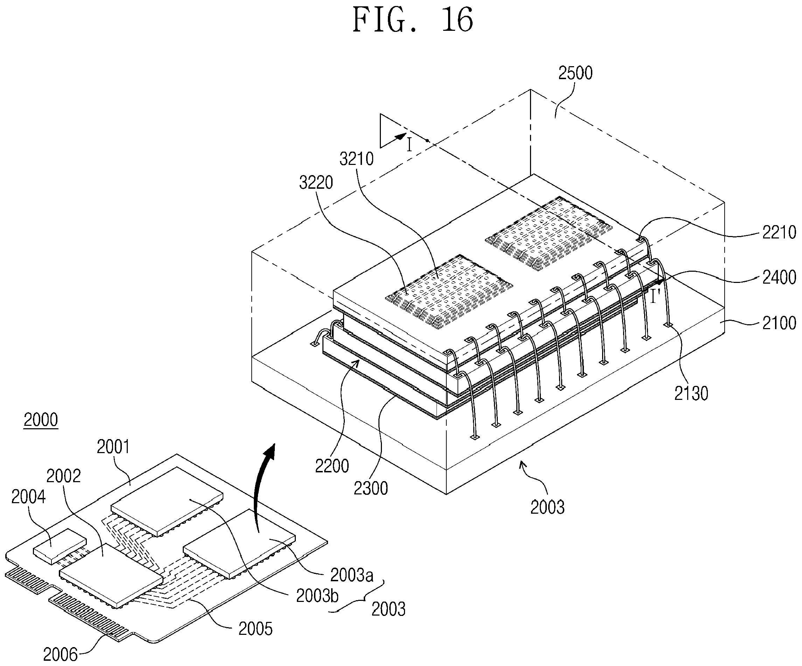

FIG. 16 illustrates a simplified perspective view showing an electronic system including a semiconductor memory device according to some embodiments of the present inventive concepts.

Referring to FIG. 16, an electronic system 2000 of an embodiment may include a main board 2001, a controller 2002 mounted on the main board 2001, one or more semiconductor packages 2003, and a dynamic random access memory (DRAM) 2004. The semiconductor package 2003 and the DRAM 2004 may be connected to the controller 2002 through wiring patterns 2005 formed on the main board 2001.

The main board 2001 may include a connector 2006 including a plurality of pins that are provided to have connection with an external host. The number and arrangement of the plurality of pins on the connector 2006 may vary based on a communication interface between the electronic system 2000 and the external host. In some embodiments, the electronic system 2000 may communicate with the external host through one or more interfaces, for example, universal serial bus (USB), peripheral component interconnect express (PIC-Express), serial advanced technology attachment (SATA), and M-PHY for universal flash storage (UFS). In some embodiments, the electronic system 2000 may operate with power supplied through the connector 2006 from the external host. The electronic system 2000 may further include a power management integrated circuit (PMIC) by which the power supplied from the external host is distributed to the controller 2002 and the semiconductor package 2003.

The controller 2002 may write data to the semiconductor package 2003, may read data from the semiconductor package 2003, or may increase an operating speed of the electronic system 2000.

The DRAM 2004 may be a buffer memory that reduces a difference in speed between the external host and the semiconductor package 2003 that serves as a data storage space. The DRAM 2004 included in the electronic system 2000 may operate as a kind of cache memory, and may provide a space for temporary data storage in a control operation of the semiconductor package 2003. When the DRAM 2004 is included in the electronic system 2000, the controller 2002 may include not only a NAND controller for controlling the semiconductor package 2003, but a DRAM controller for controlling the DRAM 2004.

The semiconductor package 2003 may include first and second semiconductor packages 2003a and 2003b that are spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesion layers 2300 disposed on bottom surfaces of the semiconductor chips 2200, connection structures 2400 that electrically connect the semiconductor chips 2200 to the package substrate 2100, and a molding layer 2500 that lies on the package substrate 2100 and covers the semiconductor chips 2200 and the connection structures 2400.

The package substrate 2100 may be a printed circuit board including upper pads 2130. Each of the semiconductor chips 2200 may include one or more input/output pads 2210. The input/output pad 2210 may correspond to the input/output pad 1101 of FIG. 15. Each of the semiconductor chips 2200 may include stack structures 3210 and vertical structures 3220. Each of the semiconductor chips 2200 may include the aforementioned semiconductor memory device according to some embodiments.

In some embodiments, the connection structure 2400 may be a bonding wire that electrically connects the input/output pad 2210 to the upper pad 2130. Therefore, on each of the first and second semiconductor packages 2003a and 2003b, the semiconductor chips 2200 may be electrically connected to each other in a bonding wire manner, and may be electrically connected to the upper pads 2130 of the package substrate 2100. In some embodiments, on each of the first and second semiconductor packages 2003a and 2003b, the semiconductor chips 2200 may be electrically connected to each other through connection structures such as through silicon vias (TSV) instead of the connection structures 2400 shaped like bonding wires.

In some embodiments, the controller 2002 and the semiconductor chips 2200 may be included in a single package. For example, the controller 2002 and the semiconductor chips 2200 may be mounted on an interposer substrate other than the main board 2001, and may be connected to each other through wiring lines formed on the interposer substrate.

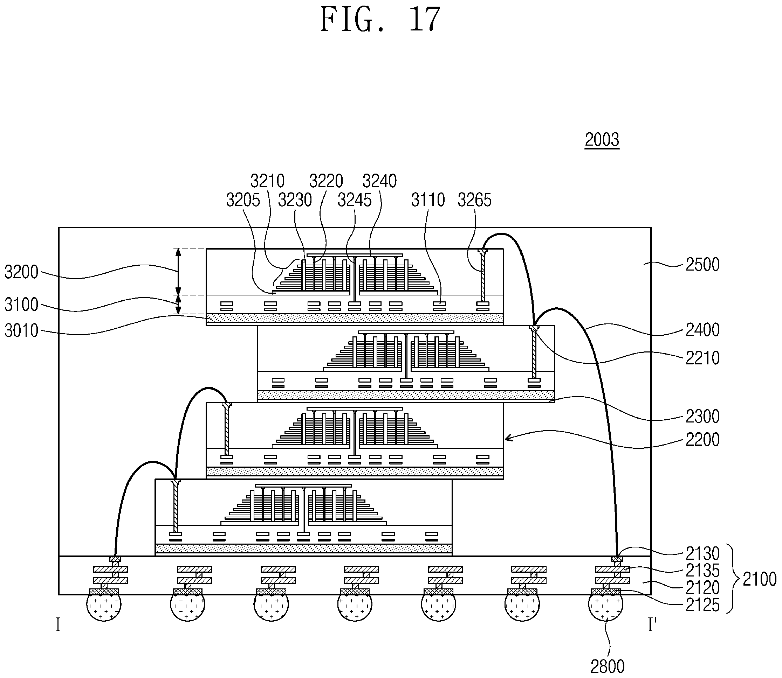

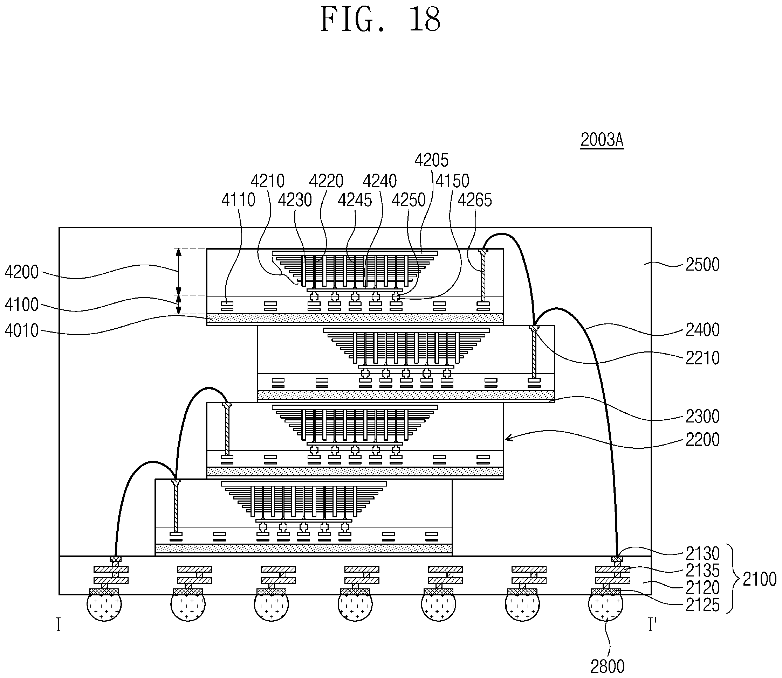

FIGS. 17 and 18 illustrate simplified cross-sectional views showing a semiconductor package according to some embodiments. FIGS. 17 and 18 each depicts an example of the semiconductor package illustrated in FIG. 16, conceptually showing a section taken along line I-I' of the semiconductor package disclosed in FIG. 16.

Referring to FIG. 17, a printed circuit board may be used as the package substrate 2100 of the semiconductor package 2003. The package substrate 2100 may include a package substrate body 2120, upper pads 2130 (see FIG. 16) disposed on a top surface of the package substrate body 2120, lower pads 2125 disposed or exposed on a bottom surface of the package substrate body 2120, and internal wiring lines 2135 by which the upper pads 2130 and the lower pads 2125 are electrically connected to each other in the package substrate body 2120. The upper pads 2130 may be electrically connected to the connection structures 2400. The lower pads 2125 may be connected through conductive connectors 2800 to the wiring patterns 2005 in the main board 2001 of the electronic system 2000 as illustrated in FIG. 16.

Each of the semiconductor chips 2200 may include a semiconductor substrate 3010, and may also include a first structure 3100 and a second structure 3200 that are sequentially stacked on the semiconductor substrate 3010.

The first structure 3100 of FIG. 17 and a first structure 4100 of FIG. 18 may correspond to a peripheral circuit structure discussed above with respect to some embodiments, and the second structure 3200 of FIG. 17 and a second structure 4200 of FIG. 18 may correspond to a cell array structure discussed above in some embodiments.

The first structure 3100 may include a peripheral circuit region including peripheral wiring lines 3110. The second structure 3200 may include a source structure 3205, a stack structure 3210 on the source structure 3205, vertical structures 3220 and separation structures 3230 that penetrate the stack structure 3210, bit lines 3240 electrically connected to the vertical structures 3220, and cell contact plugs electrically connected to word lines (see WL of FIG. 15) of the stack structure 3210. One or more of the first structure 3100, the second structure 3200, and the semiconductor chips 2200 may further include separation structures discussed above.

Each of the semiconductor chips 2200 may include one or more through wiring lines 3245 that extend into the second structure 3200 and are electrically connected to the peripheral wiring lines 3110 of the first structure 3100. The through wiring line 3245 may be disposed outside the stack structure 3210 and may further be disposed to penetrate the stack structure 3210. Each of the semiconductor chips 2200 may further include one or more input/output pads 2210 (see FIG. 16) electrically connected to the peripheral wiring lines 3110 of the first structure 3100.

Referring to FIG. 18, a semiconductor package 2003A may be configured such that each of semiconductor chips 2200 may include a semiconductor substrate 4010, a first structure 4100 on the semiconductor substrate 4010, a second structure 4200 to which the first structure 4100 is bonded in a wafer bonding manner on the first structure 4100.

The first structure 4100 may include a peripheral circuit region including peripheral wiring lines 4110 and first bonding structures 4150. The second structure 4200 may include a source structure 4205, a stack structure 4210 between the source structure 4205 and the first structure 4100, vertical structures 4220 and separation structures 4230 that penetrate the stack structure 4210, and second bonding structures 4250 that are correspondingly electrically connected to the vertical structures 4220 and word lines (see WL of FIG. 15) of the stack structure 4210. For example, the second bonding structures 4250 may be electrically connected to the vertical structures 4220 and the word lines (see WL of FIG. 15) through bit lines 4240 electrically connected to the vertical structures 4220 and through cell contact plugs electrically connected to the word lines (see WL of FIG. 15). The first bonding structures 4150 of the first structure 4100 and the second bonding structures 4250 of the second structure 4200 may be bonded to each other while being in contact with each other. The first and second bonding structures 4150 and 4250 may have their bonding portions formed of, for example, copper (Cu).

Each of the semiconductor chips 2200 may include one or more through wiring lines 4245 that extend into the second structure 4200 and are electrically connected to the peripheral wiring lines 4110 of the first structure 4100. The through wiring line 4245 may be disposed outside the stack structure 4210 and may further be disposed to penetrate the stack structure 4210.

One or more of the first structure 4100, the second structure 4200, and the semiconductor chips 2200 may further include a source structure according to some embodiments discussed above. Each of the semiconductor chips 2200 may further include input/output pads 2210 (see FIG. 16) electrically connected to the peripheral wiring lines 4110 of the first structure 4100.

The semiconductor chips 2200 of FIG. 17 or 18 may be electrically connected to each other through connection structures 2400 shaped like bonding wires. In some embodiments, in one semiconductor package including the semiconductor chips 2200 of FIG. 17 or 18, the semiconductor chips 2200 may be electrically connected to each other through connection structures 3265 or 4265 including through electrodes such as through silicon vias (TSV).

According to some embodiments, as pass transistors are separately disposed which are connected to corresponding conductive patterns, a semiconductor memory device may increase in integration, which may result in a reduction in complexity of wiring lines that connect the pass transistors to the conductive patterns.

While aspects of example embodiments have been particularly shown and described, it will be understood that various changes in form and details may be made therein without departing from the scope of the following claims.

## Claims

1. A semiconductor memory device, comprising:
a substrate comprising a plurality of pass transistor regions;
a peripheral circuit structure comprising a plurality of pass transistors on the plurality of pass transistor regions; and
a cell array structure on the peripheral circuit structure, the cell array structure comprising a plurality of cell array regions and a plurality of connection regions that are alternately arranged along a first direction,
wherein the cell array structure further comprises a stack structure comprising a plurality of conductive patterns vertically stacked and correspondingly connected to the plurality of pass transistors,
wherein the stack structure comprises a plurality of stepwise structures on the plurality of connection regions, and
wherein the plurality of connection regions of the cell array structure correspondingly overlap the plurality of pass transistor regions of the peripheral circuit structure.

2. The semiconductor memory device of claim 1, further comprising a plurality of cell contact plugs provided on each of the plurality of connection regions,
wherein the plurality of cell contact plugs correspondingly connect the plurality of pass transistors and ends of the plurality of conductive patterns.

3. The semiconductor memory device of claim 2, wherein the plurality of cell contact plugs penetrate the ends of the plurality of conductive patterns and correspondingly contact sidewalls of the plurality of conductive patterns.

4. The semiconductor memory device of any preceding claim, wherein the plurality of stepwise structures of the stack structure are at different levels from a top surface of the substrate.

5. The semiconductor memory device of any preceding claim, wherein the cell array structure further comprises:
a plurality of vertical structures that penetrate the stack structure on the plurality of connection regions; and
a plurality of bit lines that cross the stack structure and are connected to the plurality of vertical structures,
wherein the peripheral circuit structure further comprises a plurality of page buffer circuits connected to the plurality of bit lines, and
wherein the plurality of page buffer circuits overlap portions of the plurality of cell array regions.

6. The semiconductor memory device of any preceding claim, wherein the cell array structure comprises:
a first cell array region and a second cell array region; and
a first connection region and a second connection region,
wherein the first connection region is between the first cell array region and the second cell array region,
wherein the second cell array region is between the first connection region and the second connection region,
wherein the plurality of stepwise structures comprise a first stepwise structure and a second stepwise structure, and
wherein the plurality of conductive patterns of the stack structure comprise:
a plurality of first conductive patterns that define the first stepwise structure on the first connection region; and
a plurality of second conductive patterns that define the second stepwise structure on the second connection region.

7. The semiconductor memory device of claim 6, wherein the first stepwise structure and the second stepwise structure are at different vertical levels.

8. The semiconductor memory device of claim 6 or claim 7,
wherein the plurality of pass transistor regions comprise:
a first pass transistor region that overlaps the first connection region; and
a second pass transistor region that overlaps the second connection region, and wherein the plurality of pass transistors comprise:
a plurality of first pass transistors connected to the plurality of first conductive patterns on the first transistor region; and
a plurality of second pass transistors connected to the plurality of second conductive patterns on the second pass transistor region.

9. The semiconductor memory device of any preceding claim, wherein:
each of the plurality of connection regions comprises a pad region and a bridge region in a second direction that intersects the first direction, and
the plurality of stepwise structures of the stack structure are correspondingly provided on the pad regions of the plurality of connection regions.

10. The semiconductor memory device of claim 9, wherein:
the stack structure has a first width in the second direction parallel to a top surface of the substrate, and
each of the plurality of stepwise structures has a second width in the second direction, and the second width is less than the first width.

11. The semiconductor memory device of claim 9 or claim 10, wherein the stack structure has substantially a same thickness on each of the plurality of cell array regions.

12. The semiconductor memory device of any one of claims 9 - 11, wherein a thickness of the stack structure on the bridge regions is substantially the same as a thickness of the stack structure on the plurality of cell array regions.

13. The semiconductor memory device of any preceding claim, wherein the peripheral circuit structure further comprises a plurality of first bonding pads connected to the plurality of peripheral circuits, and
wherein the cell array structure further comprises a plurality of second bonding pads coupled to the plurality of first bonding pads.

14. The semiconductor memory device of any preceding claim, further comprising a controller electrically connected through an input/output pad to the semiconductor memory device, the controller configured to control the semiconductor memory device.
